# EUROPEAN PATENT APPLICATION

(11) **EP 4 645 362 A2**
(43) Date of publication of application: **05.11.2025**
(21) Application number: 25164543.8
(22) Date of filing: 18.03.2025
(51) Int. Cl.: H01J 37/20, H01J 37/26, H01J 37/28

(54) **FOCUSED ION BEAM SYSTEM**

(30) Priority: 12.04.2024 JP 2024064607
(71) Applicant: JEOL Ltd., Akishima, Tokyo 196-8558 (JP)
(72) Inventor: WATANABE, Jun, Tokyo, 196-8558 (JP); SAKUTA, Norimasa, Tokyo, 196-8558 (JP); FUKUDA, Tomohisa, Tokyo, 196-8558 (JP); SUZUKI, Osamu, Tokyo, 196-8558 (JP); SHIBATA, Masateru, Tokyo, 196-8558 (JP); MORIYA, Koji, Tokyo, 196-8558 (JP)
(74) Representative: Boult Wade Tennant LLP

(57) **Abstract**

There is provided a focused ion beam (FIB) system having a sample chamber which can be effectively used. The focused ion beam system (100) comprises: an electron optical column (2) having an optical system for directing an ion beam at a sample; a sample chamber (8) in which the sample is placed and which can be maintained in a vacuum state; a sample holder (5) having a shaft (56) and a sample holding portion (50) which is formed in a front end of the shaft (56) and which is operative to hold the sample; and a sample stage assembly (6) for detachably holding the sample holder (5). The sample stage assembly (6) has a first drive mechanism (66) for moving the sample holder (5) and a second drive mechanism (68) for moving the sample holder (5) and the first drive mechanism (66) as a unit along an axis of the shaft (56).

## Description

### BACKGROUND OF THE INVENTION

### 1. Field of the Invention

The present invention relates to a focused ion beam (FIB) system and more particularly to a focused ion beam system designed such that its sample chamber can be effectively used.

### 2. Description of the Related Art

In a focused ion beam (FIB) system, a sample can be milled by scanning its surface with a focused ion beam. With a focused ion beam system, TEM samples for transmission electron microscopy (TEM) can be prepared by milling the samples with a focused ion beam.

For example, Patent document 1 discloses a sample preparation device for inserting a TEM sample holder into a sample chamber such that the sample held on the sample holder can be milled with a focused ion beam.

### Citation List

### Patent Documents

Patent document 1: JP-A-2000-146781

In the above-described FIB system, when the TEM sample holder is inserted into the sample chamber, the sample holder is placed near the optical axis of the ion beam optical system. However, various devices including a FIB column, a SEM column for SEM observation, and a probe for picking up an extracted sample are disposed in the vicinity of the optical axis of the ion beam optical system in the sample chamber. Therefore, there is a need for a focused ion beam system permitting effective use of the sample chamber.

### SUMMARY OF THE INVENTION

One aspect of the focused ion beam system associated with the present invention comprises:
an electron optical column having an optical system for directing an ion beam at a sample;
a sample chamber in which the sample is placed and which can be maintained in a vacuum state;
a sample holder having a shaft and a sample holding portion which is formed in a front end of the shaft and which is operative to hold the sample; and
a sample stage assembly for detachably holding the sample holder.

The sample stage assembly has: a first drive mechanism for moving the sample holder; and a second drive mechanism for moving the sample holder and the first drive mechanism as a unit along an axis of the shaft.

In this focused ion beam system, the second drive mechanism can move the first drive mechanism and the sample holder as a unit and, therefore, effective use of the sample chamber can be made.

### BRIEF DESCRIPTION OF THE DRAWINGS

FIG. 1 is a schematic diagram illustrating one example of the configuration of a focused ion beam (FIB) system associated with a first embodiment of the present invention.
FIG. 2 is a schematic perspective view of a sample holder.
FIG. 3 is a schematic cross-sectional view of the sample holder of FIG. 2.
FIGS. 4 and 5 are schematic perspective views of a sample holding portion of the sample holder of FIGS. 2 and 3.
FIGS. 6 and 7 are schematic cross-sectional views of a sample stage assembly.
FIG. 8 is a diagram illustrating the operation of a Y-axis driver.
FIG. 9 is a flowchart illustrating one example of a method of preparing a sample.
FIGS. 10 and 11 are schematic cross-sectional views of a sample stage assembly for use in a focused ion beam system associated with a second embodiment of the invention.

### DETAILED DESCRIPTION OF THE INVENTION

The preferred embodiments of the present invention are hereinafter described in detail with reference to the drawings. It is to be understood that the embodiments provided below are not intended to unduly restrict the scope and content of the present invention delineated by the appended claims and that not all the configurations described below are essential constituent components of the invention.

### 1. First Embodiment

### 1.1. Focused Ion Beam System

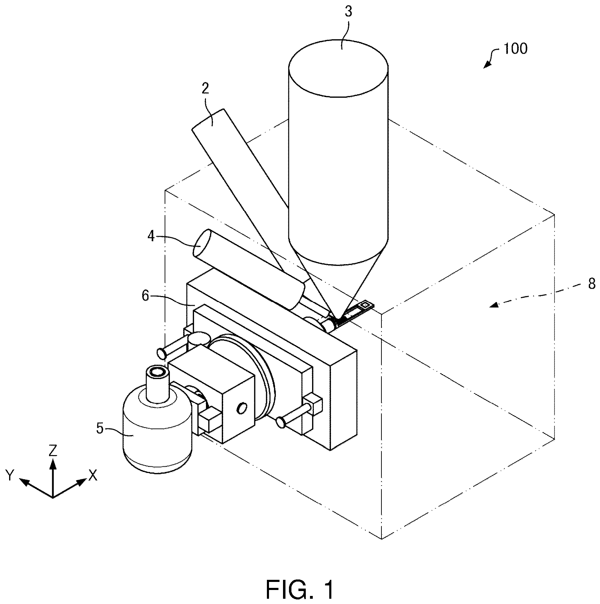

A focused ion beam (FIB) system associated with a first embodiment is first described by referring to FIG. 1, which shows one example of configuration of the FIB system, 100. X, Y, and Z axes are shown as three mutually perpendicular axes in FIG. 1.

The focused ion beam system 100 functions as a focused ion beam (FIB) system and also as a scanning electron microscope (SEM). The FIB system 100 includes a FIB column 2, a SEM column 3, a probe 4, a sample holder 5, a sample stage assembly 6, and a sample chamber 8.

The FIB column 2 has an ion beam optical system for forming and scanning a focused ion beam. The FIB column 2 includes an ion source (ion gun) for emitting an ion beam, lenses for focusing the ion beam, and deflectors for scanning the focused ion beam. These lenses and deflectors together constitute an ion beam optical system. A sample can be milled by scanning it with a focused ion beam formed by the FIB column 2. Milling by a focused ion beam may hereinafter be referred to also FIB milling.

The SEM column 3 includes an electron beam optical system for forming and scanning an electron beam. In particular, the SEM column 3 includes an electron source (electron gun) for emitting an electron beam, lenses for focusing the electron beam, and scan coils for scanning the electron beam. These lenses and scan coils together constitute the electron beam optical system.

Furthermore, the FIB system 100 includes a detector (not shown) for detecting electrons emanating from a sample in response to irradiation of the sample with an electron beam. Therefore, the FIB system 100 allows for SEM imaging.

The optical axis of the ion beam optical system of the FIB column 2 and the optical axis of the electron beam optical system of the SEM column 3 intersect each other. FIB milling and SEM imaging of the sample can be performed by placing the sample at the intersection point between these two optical axes.

The probe 4 is used to pick up the sample milled with a focused ion beam. For example, a slice cut out of a bulk sample with the focused ion beam and measuring several micrometers square can be picked up with the probe 4.

The sample holder 5 holds the sample. The sample is placed in the sample chamber 8 while held in the sample holder 5. The sample stage assembly 6 detachably holds the sample holder 5 and can move the sample held in the sample holder 5 in a horizontal direction along the X and Y axes and in an up-and-down direction along the Z axis. Furthermore, the sample stage assembly 6 can rotate or tilt the sample about the X axis. In this way, the sample stage assembly 6 is a goniometer stage capable of moving and tilting the sample. A sample is accommodated in the sample chamber 8, which in turn can be maintained in a vacuum state by a vacuum pumping system (not shown).

### 1.2. Sample Holder

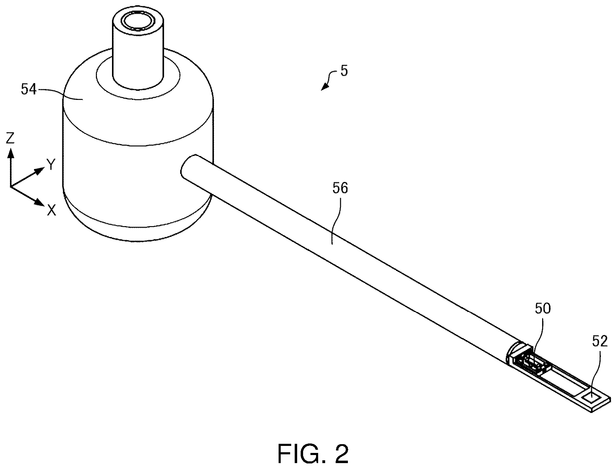

FIG. 2 is a schematic perspective view of the sample holder 5. The sample holder 5 is shared between a transmission electron microscope (TEM) and the focused ion beam system 100. The sample holder 5 includes a sample holding portion 50, a bulk sample support stage 52, a refrigerant tank 54, and a shaft 56 as shown.

The sample holding portion 50 is formed in the front end of the shaft 56 and can hold a grip for securing a TEM sample. The bulk sample stage 52 holds a bulk sample. Assuming that +X direction lies from the rear end to the front end of the shaft 56 along the axis of the shaft 56 as shown in FIG. 2, the sample holding portion 50 and the bulk sample stage 52 are placed in this order in the +X direction. That is, the bulk sample stage 52 is disposed more forwardly of the sample holding portion 50 in the +X direction. The bulk sample stage 52 can be attached to and detached from the front end of the shaft 56.

The refrigerant tank 54 is mounted in the rear end of the shaft 56 and filled with a refrigerant such as liquid nitrogen.

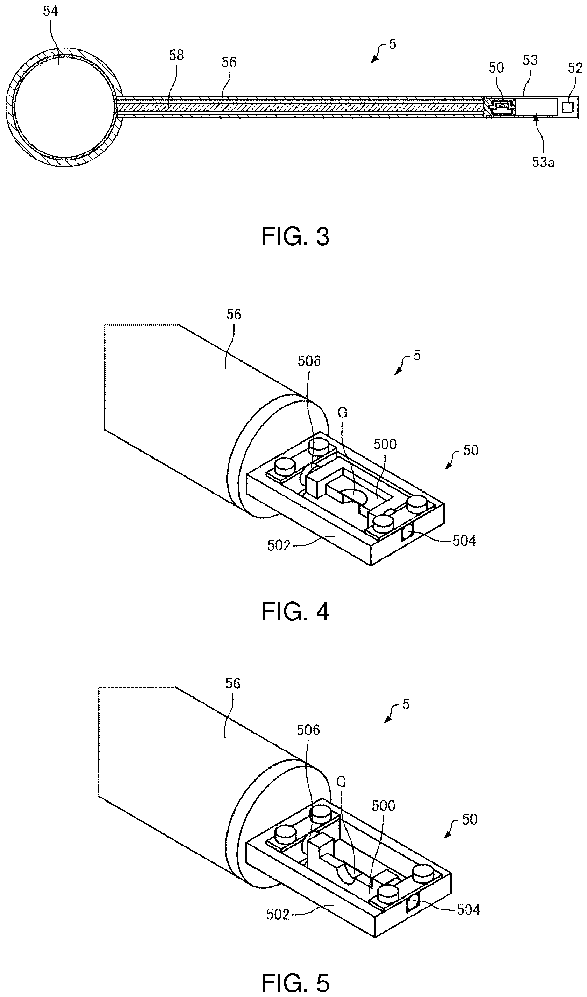

FIG. 3 is a schematic cross-sectional view of the sample holder 5. A heat transfer member 58 is received in the shaft 56 and thermally connects the refrigerant tank 54 both to the sample holding portion 50 and to the bulk sample stage 52. Therefore, the sample holding portion 50 and the bulk sample stage 52 can be cooled by filling the refrigerant tank 54 with a refrigerant such as liquid nitrogen.

The bulk sample stage 52 having a mounting portion 53 is detachably mounted to the shaft 56 by the mounting portion 53. The mounting portion 53 whose front end, for example, is inserted over the shaft 56 is secured with screws or the like. The mounting portion 53 is provided with an opening portion 53a to reduce the gradient of the thermal capacity. Consequently, the difference in times in which the sample holding portion 50 and the bulk sample stage 52 are cooled down, respectively, and temperature differences can be reduced. The sample holder 5 may have a heater (not shown) for heating the sample.

The shaft 56 is thermally insulated from the refrigerant tank 54, heat transfer member 58, sample holding portion 50, and bulk sample stage 52, whereby the effects of cooling of a vacuum seal member such as an O-ring (not shown) mounted on the shaft 56 can be reduced.

FIGS. 4 and 5 are schematic perspective views of the sample holding portion 50 of the sample holder 5. The sample holding portion 50 includes a grid holder 500, a frame 502, and a grid holder shaft 504. The grid holder 500 holds a TEM grid G. A slice cut out of the bulk sample is secured to the grid G, and then the slice is sufficiently thinned to a thickness enabling TEM imaging. Thus, a TEM sample can be prepared.

In this embodiment, a TEM sample is secured to the grid G. A member for securing a TEM sample is not restricted to grids. There is no restriction on the configuration of the sample holding portion 50 as long as it can hold a member for securing a TEM sample.

The grid holder 500 is fastened to the frame 502 by the grid holder shaft 504. The grid holder 500 can rotate about the grid holder shaft 504. Accordingly, with the sample holder 5, the posture of the grid G can be varied as shown in FIGS. 4 and 5. For example, where a sample is observed by TEM, the grid holder 500 is placed parallel to the frame 502, and the grid G is laid down. Furthermore, if a sample secured to the grid G is thinned by an ion beam, for example, the grid holder 500 is made perpendicular to the frame 502 as shown in FIG. 5, and the grid G is placed upright. For instance, where a slice picked up is secured to the grid G, if the grid G is placed upright, the probe 4 can have easy access to the grid G.

A leaf spring ring 506 is squeezed in between the frame 502 and the grid holder 500. A spring force generated by the leaf spring ring 506 assures that the grid holder 500 is connected to the frame 502. This can enhance the heat transfer between the frame 502 and the grid holder 500.

### 1.3. Sample Stage Assembly

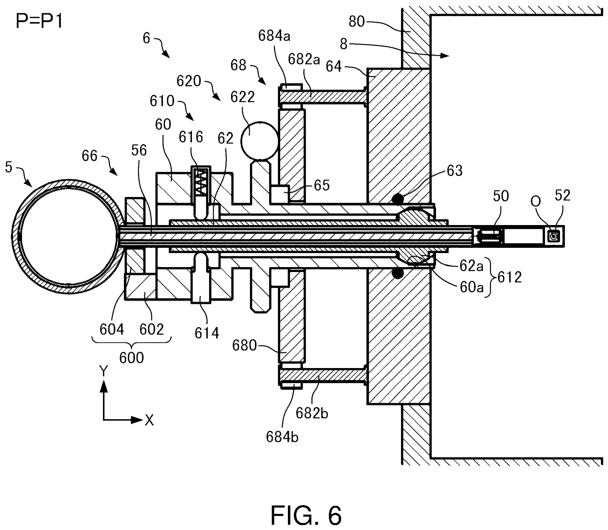

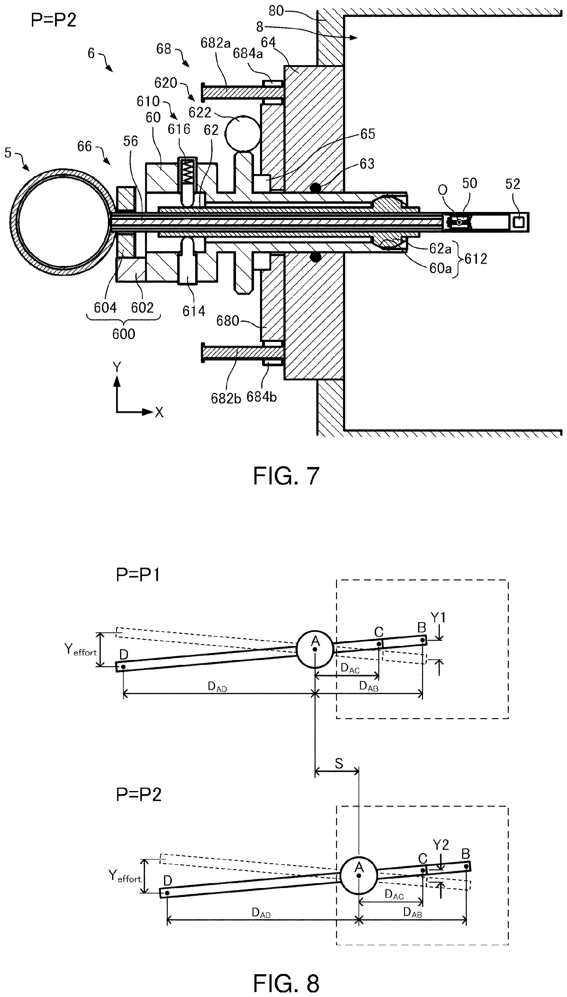

FIGS. 6 and 7 are schematic cross-sectional views of the sample stage assembly 6. As shown, the sample stage assembly 6 has a base holder 60, a spherical pipe 62 (one example of cylindrical member), a base plate 64, a first drive mechanism 66, and a second drive mechanism 68.

The sample holder 5 is inserted in the spherical pipe 62 which in turn is accommodated in the base holder 60. The base holder 60 is supported by a stage base 680 of the second drive mechanism 68. That is, the spherical pipe 62 in which the sample holder 5 is inserted is supported to the stage base 680 via the base holder 60. The first drive mechanism 66 is mounted on the base holder 60.

A sample chamber wall 80 that partitions the sample chamber 8 is affixed to the base plate 64. The base plate 64 is provided with a through-hole in which the base holder 60 is inserted. A gap between the base holder 60 and the base plate 64 is hermetically sealed by an O-ring 63. The O-ring 63 permits the base holder 60 to slide through the through-hole in the base holder 60.

The first drive mechanism 66 has an X-axis driver 600, a Y-axis driver 610, and a rotary driver 620. Furthermore, the first drive mechanism 66 has a Z-axis driver (not shown).

The X-axis driver 600 moves the sample holder 5 along the X axis and has an X-axis actuator 602 and a holding plate 604. The X-axis actuator 602 is a one-axis actuator which moves the holding plate 604 along the X axis, for example, by the power of a motor. The holding plate 604 supports the sample holder 5. Therefore, the sample holder 5 can be moved along the X axis by causing the X-axis actuator 602 to move the holding plate 604 along the X axis.

The Y-axis driver 610 moves the sample holding portion 50 and the bulk sample stage 52 along the Y axis and has a spherical bearing 612, a Y-axis actuator 614, and a holding shaft 616.

The spherical bearing 612 is made up of the base holder 60 and the spherical pipe 62. The base holder 60 has a front end in which a spherical slip surface 60a acting as an outer ring is formed. A spherical inner ring 62a is mounted in the front end of the spherical pipe 62. The spherical bearing 612 is built by fitting the spherical inner ring 62a over the spherical slip surface 60a.

The spherical pipe 62 is sandwiched along the Y axis between the Y-axis actuator 614 and the holding shaft 616. The Y-axis actuator 614 is in contact with the outer peripheral surface of the spherical pipe 62 on the negative side of the Y axis, while the holding shaft 616 is in contact with the outer peripheral surface on the positive side. The Y-axis actuator 614 moves linearly, for example, along the Y axis. For example, the Y-axis actuator 614 is a one-axis actuator driven by a motor. The holding shaft 616 biases the spherical pipe 62 in the -Y direction by the force of a spring.

In the Y-axis driver 610, the Y-axis actuator 614 moves rectilinearly along the Yaxis and thus the shaft 56 is rotated about a fulcrum consisting of the spherical bearing 612 according to the principle of leverage. Consequently, the sample holding portion 50 at the front end of the shaft 56 and the bulk sample stage 52 can be moved along the Y axis. At this time, the sample holding portion 50 and the bulk sample stage 52 can be placed in position along the Y axis according to the balanced position between the Y-axis actuator 614 and the holding shaft 616. Note that the positional relationship between the Y-axis actuator 614 and the holding shaft 616 may be reversed in a manner not illustrated.

The Z-axis driver operates to move the sample holding portion 50 and the bulk sample stage 52 along the Z axis in a manner not illustrated. The Z-axis driver is similar in configuration to the Y-axis driver 610 except that the angular position has been rotated through 90°. In particular, in the Y-axis driver 610, the spherical pipe 62 is sandwiched along the Y axis between the Y-axis actuator 614 and the holding shaft 616. In the Z-axis driver, the spherical pipe 62 is sandwiched along the Z axis between a Z-axis actuator and a holding shaft. Consequently, the sample holding portion 50 and the bulk sample stage 52 can be moved along the Z axis.

The rotary driver or tilting driver 620 has a rotary actuator 622 that rotates the base holder 60. As the base holder 60 rotates, the spherical pipe 62 rotates about the axis of the shaft 56. As a result, the sample holding portion 50 and the bulk sample stage 52 can be rotated or tilted about the X axis. For example, the rotary driver 620 can rotate the sample holding portion 50 and the bulk sample stage 52 through approximately 180°. Thus, the front and rear surfaces of a sample can be observed by SEM.

The second drive mechanism 68 moves the sample holder 5 and the first drive mechanism 66 as a unit along the axis of the shaft 56, i.e., along the X axis. The second drive mechanism 68 moves the sample holder 5 and the first drive mechanism 66 between a first position P1 shown in FIG. 6 and a second position P2 shown in FIG. 7. In the first position P1, the bulk sample stage 52 lies at the intersection point O between the optical axis of the FIB column 2 and the optical axis of the SEM column 3. In the second position P2, the sample holding portion 50 lies at the intersection point O.

If the bulk sample stage 52 lies at the intersection point O, for example, a bulk sample secured to the bulk sample stage 52, can be FIB milled and observed by SEM. Also, if the sample holding portion 50 lies at the intersection point O, a sample held on the sample holding portion 50 (e.g., a sample secured to the grid G) can be FIB milled and observed by SEM.

The second drive mechanism 68 has the stage base 680, a first drive shaft 682a, a second drive shaft 682b, a first drive actuator 684a, and a second drive actuator 684b. The base holder 60 is connected to the stage base 680 via a bearing 65. Therefore, when the rotary driver 620 rotates the base holder 60, the base holder 60 can be rotated independently of the stage base 680. Mounted to the base holder 60 are the X-axis driver 600, Y-axis driver 610, rotary driver 620, and Z-axis driver. That is, the first drive mechanism 66 is mounted to the base holder 60. The base holder 60 supports the spherical pipe 62 into which the sample holder 5 is inserted. Accordingly, the sample holder 5 and the first drive mechanism 66 can be moved as a unit by movement of the base holder 60 caused by the second drive mechanism 68.

The first drive shaft 682a and the second drive shaft 682b are secured to the stage base 680 and have their central axes parallel to the X axis. The first drive actuator 684a and the second drive actuator 684b are mounted at opposite ends of the stage base 680. The first drive actuator 684a moves the stage base 680 along the first drive shaft 682a. The second drive actuator 684b moves the stage base 680 along the second drive shaft 682b. Accordingly, the stage base 680 can be moved along the X axis by the first drive actuator 684a and the second drive actuator 684b. As a consequence, the sample holder 5 and the first drive mechanism 66 can be moved as a unit by the second drive mechanism 68. Each of the first drive actuator 684a and the second drive actuator 684b has a stroke length substantially identical, for example, to the distance between the sample holding portion 50 and the bulk sample stage 52.

For example, the first drive actuator 684a and the second drive actuator 684b are air cylinders. There is no restriction on the structure of the first and second drive actuators 684a, 684b as long as they can move the stage base 680 along the X axis. For example, they may be motor-driven one-axis actuators.

When the sample holder 5 and the first drive mechanism 66 are located in the second position P2, the sample holder 5 is drawn into the sample chamber 8 in a vacuum state. The draw-in force presses the stage base 680 against the base plate 64 as shown in FIG. 7, so that the sample holder 5 and the first drive mechanism 66 are secured more reliably. Consequently, when the slice secured to the grip G is FIB milled, the effects of vibrations can be reduced, whereby finer milling can be accomplished.

In the foregoing description, the first drive shaft 682a, the second drive shaft 682b, the first drive actuator 684a, and the second drive actuator 684b together function as a base driver for moving the stage base 680 along the axis of the shaft 56. The configuration of the base driver for moving the stage base 680 is not restricted to this configuration. For example, the base driver may use the power generated by a motor to move the stage base 680. In addition, in the foregoing description, there are two drive shafts. It may suffice to use only one drive shaft. Three or more drive shafts may also be used.

### 1.4. Amount of Movement of Sample Stage Assembly in the Y direction

FIG. 8 illustrates the operation of the Y-axis driver 610. In particular, FIG. 8 illustrates an operative state in which the sample holder 5 and the first drive mechanism 66 shown in FIG. 6 are in the first position P, i.e., the bulk sample stage 52 is in the intersection point O, and another operative state in which the sample holder 5 and the first drive mechanism 66 shown in FIG. 7 are in the second position P2, i.e., the sample holding portion 50 is in the intersection point O.

As described previously, movement of the sample holding portion 50 and the bulk sample stage 52 in the Y direction caused by the Y-axis driver 610 uses the principle of leverage. In FIG. 8, let D_{AB} be the distance between a fulcrum A created by the spherical bearing 612 and a point of action B where the bulk sample stage 52 is located. Let D_{AC} be the distance between the fulcrum A and a point of action C where the sample holding portion 50 is located. Also, let D_{AD} be the distance between the fulcrum A and a point of effort D where the Y-axis actuator 614 is located. Furthermore, let S be the distance between the first position P1 and the second position P2. That is, the distance S is the stroke length of the second drive mechanism 68. Additionally, let Y_{effort} be the working stroke length of the Y-axis driver 610.

The second drive mechanism 68 moves the sample holder 5 and the first drive mechanism 66 as a unit. Therefore, when the second drive mechanism 68 moves the holder 5 and the first drive mechanism 66 from the first position P1 to the second position P2 by the distance S, all of the fulcrum A, the point of action B, the point of action C, and the point of effort D move for the distance S, although the distance D_{AC}, the distance D_{AB}, and the distance D_{AD} remain unchanged.

If the Y-axis driver 610 moves the point of effort D along the Y axis by the working stroke length Y_{effort}, the distance Y1 traveled along the Y axis by the point of action B where the bulk sample stage 52 is located is greater than the distance Y2 traveled along the Y axis by the point of action C where the sample holding portion 50 is located because the distance D_{AC} is greater the distance D_{AB}. That is, Y1 > Y2. Therefore, the range in which the bulk sample stage 52 can be moved can be set greater than the range in which the sample holding portion 50 can be moved.

In the focused ion beam system 100, therefore, the bulk sample stage 52 has a greater range of movement and so the system can cope with larger samples. Furthermore, the sample holding portion 50 can provide enhanced accuracy of movement and thus the system can cope with minute or microscopic samples. In the focused ion beam system 100, a sample stage having a simple configuration and coping with large bulk samples and minute samples can be accomplished.

### 1.5. Method of Preparing Sample

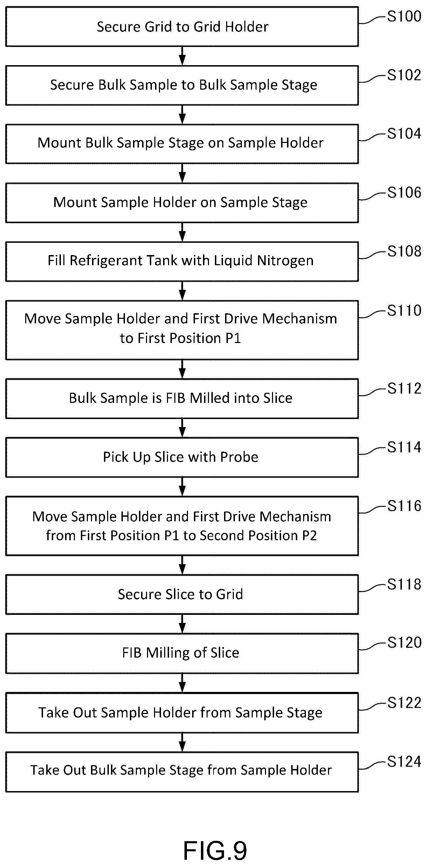

FIG. 9 is a flowchart illustrating one example of a method of preparing a sample using the focused ion beam system 100. First, as shown in FIG. 5, the grid G is secured to the grid holder 500 of the sample holder 5 (step S100). At this time, the grid holder 500 is rotated and the grid G is put upright as shown in FIG. 5.

Then, a bulk sample is secured to the bulk sample stage 52 (step S102), and the bulk sample stage 52 is mounted to the sample holder 5 as shown in FIGS. 2 and 3 (step S104).

Then, as shown in FIG. 1, the sample holder 5 is mounted to the sample stage assembly 6 (step S106). This can be effected by inserting the sample holder 5 into the spherical pipe 62.

Then, the refrigerant tank 54 is filled with liquid nitrogen (step S108). Consequently, the sample holding portion 50 and the bulk sample stage 52 can be cooled. As a result, the bulk sample can be cooled.

Then, as shown in FIG. 6, the sample holder 5 and the first drive mechanism 66 are moved as a unit into the first position P1 by the second drive mechanism 68 (step S110). This brings the bulk sample stage 52 into the intersection point O between the optical axis of the FIB column 2 and the optical axis of the SEM column 3. The bulk sample can be FIB milled and observed by SEM.

A slice is then cut out of the bulk sample by FIB milling the bulk sample (step S112). Then, the slice cut out is picked up with the probe 4 (step S114).

Then, as shown in FIG. 7, the sample holder 5 and the first drive mechanism 66 are moved as a unit from the first position P1 to the second position P2 by the second drive mechanism 68 (step S116). Consequently, the sample holding portion 50 is placed in the intersection point O.

Then, the slice picked up with the probe 4 is secured to the grid G (step S118). The slice is sufficiently thinned by the focused ion beam to permit TEM imaging while secured to the grid G (step S120). As described previously, the refrigerant tank 54 is filled with liquid nitrogen and, therefore, the FIB milling of the bulk sample at step S110 and the FIB milling of the slice at step S118 can be performed in a cooled state. As a consequence, damage to the sample due to FIB milling can be reduced.

Then, the sample holder 5 is returned to room temperature and the sample holder 5 is removed from the sample stage assembly 6 (step S122). Subsequently, the bulk sample stage 52 is taken out from the sample holder 5 (step S124). Then, the grid holder 500 is rotated and the grid G is laid down as shown in FIG. 4. The sample holder 5 is inserted into a transmission electron microscope. Consequently, the sample cut out of the bulk sample can be observed by

### TEM.

In the foregoing description, a TEM sample is prepared. The focused ion beam system 100 is capable of preparing other samples such as SEM samples and EPMA (electron probe microanalyzer) samples.

### 1.6. Advantageous Effects

The focused ion beam system 100 comprises: the FIB column 2 having the ion beam optical system for directing an ion beam at a sample; the sample chamber 8 in which the sample is placed and which can be maintained in a vacuum state; the sample holder 5 having the shaft 56 and the sample holding portion 50 which is formed in a front end of the shaft and is operative to hold the sample; and the sample stage assembly 6 for detachably holding the sample holder 5. The sample stage assembly 6 has: the first drive mechanism 66 for moving the sample holder 5; and the second drive mechanism 68 for moving the sample holder 5 and the first drive mechanism 66 as a unit along the axis of the shaft 56.

Therefore, in the focused ion beam system 100, the sample holder 5 and the first drive mechanism 66 can be moved as a unit. Consequently, in the focused ion beam system 100, either the sample holding portion 50 or the bulk sample stage 52 can be placed at the intersection point O between the optical axis of the FIB column 2 and the optical axis of the SEM column 3 by the second drive mechanism 68. Hence, effective use of the sample chamber 8 can be made.

For example, in the focused ion beam system 100, when a bulk sample is milled, the sample holding portion 50 can be placed remotely from the point of intersection O by the second drive mechanism 68. When the sample held on the sample holding portion 50 is milled, the sample holding portion 50 can be placed at the point of intersection O. Consequently, in the focused ion beam system 100, space in the vicinity of the point of intersection O in the sample chamber 8 can be effectively used.

In the focused ion beam system 100, the second drive mechanism 68 has: the stage base 680 providing support of the spherical pipe 62 acting as a cylindrical member into which the sample holder 5 is inserted; and the drive section for moving the stage base 680 along the axis of the shaft 56, the drive section including the first drive shaft 682a, the second drive shaft 682b, the first drive actuator 684a, and the second drive actuator 684b. The sample stage assembly 6 has the base plate 64 secured to the sample chamber wall 80 that partitions the sample chamber 8. When the sample holder 5 and the first drive mechanism 66 are in the second position P2, the sample holder 5 is drawn into the sample chamber 8 in a vacuum state. The draw-in force pushes the stage base 680 against the base plate 64. Therefore, in the focused ion beam system 100, the sample holder 5 and the first drive mechanism 66 can be secured more reliably. Consequently, if a slice secured to the grid G is FIB milled, the effects of vibrations can be reduced. Thus, finer milling can be accomplished.

In the focused ion beam system 100, the first drive mechanism 66 includes the rotary driver 620 for rotating the sample holding portion 50 by rotating the shaft 56 about its axis. Therefore, the focused ion beam system 100 permits both surfaces of a slice to be observed by SEM, for example, during FIB milling.

In the focused ion beam system 100, the sample holder 5 has the bulk sample stage 52 for holding a bulk sample. The sample holding portion 50 and the bulk sample stage 52 are arranged in this order along the axis of the shaft 56 in the + X direction going from the rear end to the front end of the shaft 56. Therefore, in the focused ion beam system 100, either the sample holding portion 50 or the bulk sample stage 52 can be placed in the point of intersection O by moving the sample holder 5 and the first drive mechanism 66 as a unit by the second drive mechanism 68. Consequently, with the focused ion beam system 100, a slice cut out by FIB milling a bulk sample secured to the bulk sample stage 52 can be FIB milled after it is fastened to the grid G held to the sample holding portion 50. Thus, with the focused ion beam system 100, a TEM sample can be easily prepared from a bulk sample.

In the focused ion beam system 100, the second drive mechanism 68 moves the sample holder 5 and the first drive mechanism 66 between the first position P1 where the bulk sample stage 52 is located at the point of intersection O and the second position P2 where the sample holding portion 50 is located at the point of intersection O. Therefore, with the focused ion beam system 100, a bulk sample secured to the bulk sample stage 52 is FIB milled and cut out as a slice. The slice is secured to the grid G held to the sample holding portion 50 and can be FIB milled. Consequently, with the focused ion beam system 100, a TEM sample can be easily prepared from a bulk sample.

In the focused ion beam system 100, the first drive mechanism 66 includes: the spherical bearing 612 into which the sample holder 5 is inserted and which rotatably supports the sample holder 5; and the Y-axis driver 610 for rotating the sample holder 5 about the fulcrum A consisting of the spherical bearing 612. The distance D_{AB} between the fulcrum A and the bulk sample stage 52 is greater than the distance D_{AC} between the fulcrum A and the sample holding portion 50. Therefore, in the focused ion beam system 100, the range of movement of the bulk sample stage 52 can be expanded.

In the focused ion beam system 100, neither the distance D_{AC} between the fulcrum A and the sample holding portion 50 nor the distance D_{AB} between the fulcrum A and the bulk sample stage 52 varies because the second drive mechanism 68 moves the sample holder 5 and the first drive mechanism 66 as a unit. Therefore, in the focused ion beam system 100, if the second drive mechanism 68 moves the sample holder 5 and the first drive mechanism 66 as a unit, the range of movement of the bulk sample stage 52 can be expanded.

In the focused ion beam system 100, the sample holder 5 includes the refrigerant tank 54 mounted to the rear end of the shaft 56 and the heat transfer member 58 thermally interconnecting the refrigerant tank 54 and the sample holding portion 50. Therefore, in the focused ion beam system 100, a sample can be FIB milled while being cooled. Hence, in the focused ion beam system 100, damage to the sample due to FIB milling can be reduced.

### 2. Second Embodiment

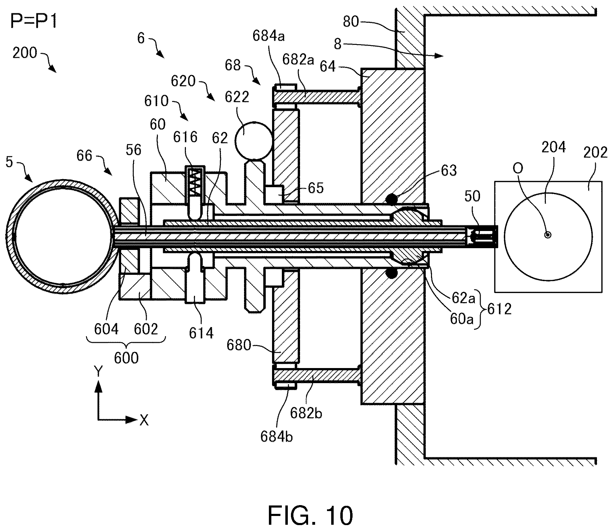

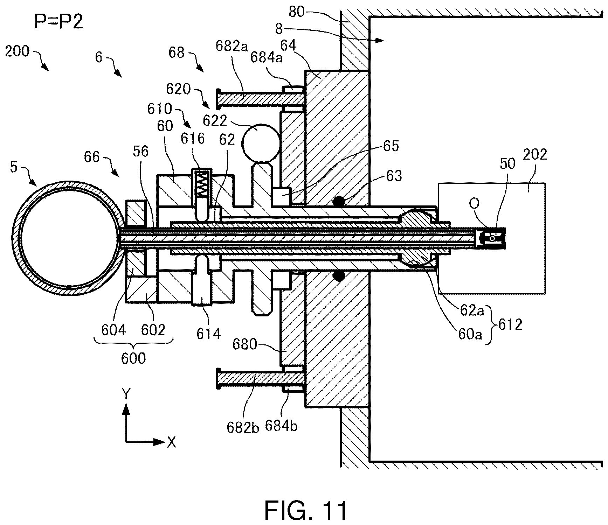

A focused ion beam system associated with a second embodiment is next described by referring to FIGS. 10 and 11 which are schematic cross-sectional views of the sample stage assembly 6 of the focused ion beam system, 200, associated with the second embodiment. FIG. 10 illustrates an operative state in which the sample holder 5 and the first drive mechanism 66 are located in the first position P1. FIG. 11 illustrates an operative state in which the sample holder 5 and the first drive mechanism 66 are located in the second position P2.

Those members of the focused ion beam system 200 associated with the second embodiment which are similar in function to their respective counterparts of the focused ion beam system 100 associated with the first embodiment are hereinafter indicated by the same reference numerals as in the foregoing figures and a detailed description thereof is omitted below.

In the above-described focused ion beam system 100, as shown in FIGS. 6 and 7, a bulk sample is FIB milled on the bulk sample stage 52 of the sample holder 5. In contrast, the focused ion beam system 200, as shown in FIGS. 10 and 11, includes a bulk sample stage 202 and a bulk sample holder 204 mounted on the sample stage 202, and a bulk sample is FIB milled in the bulk sample holder 204.

The bulk sample stage 202 is disposed inside the sample chamber 8. The bulk sample holder 204 can hold a bulk sample. The bulk sample can be FIB milled by mounting the bulk sample holder 204 on the bulk sample stage 202. The bulk sample stage 202 places the bulk sample holder 204 into the intersection point O between the optical axis of the FIB column 2 and the optical axis of the SEM column 3.

If the bulk sample holder 204 is placed at the point of intersection O as shown in FIG. 10, the sample holder 5 and the first drive mechanism 66 are located in the first position P1. Consequently, when the bulk sample is milled in the bulk sample holder 204, the sample holder 5 and the first drive mechanism 66 can be retracted away from the point of intersection O.

For example, by placing the sample holder 5 and the first drive mechanism 66 in the first position P1 as shown in FIG. 10, the spherical bearing 612 can be retracted away from the point of intersection O, e.g., outside of the sample chamber 8. The spherical bearing 612 needs inner and outer rings and so it is difficult to miniaturize the spherical bearing. Therefore, as shown in FIG. 11, if the spherical bearing 612 is close to the point of intersection O, a bulk sample may collide either against the sample holder 5 or against the first drive mechanism 66 (base holder 60, spherical pipe 62, and other parts) when the bulk sample is tilted.

In the focused ion beam system 200, the sample holder 5 and the first drive mechanism 66 can be retracted and, therefore, when a bulk sample is FIB milled using the bulk sample holder 204 on the bulk sample stage 202, the possibility that the bulk sample will collide with the sample holder 5 or the first drive mechanism 66 can be reduced.

In this way, in the focused ion beam system 200, if FIB milling is not done in the sample holding portion 50, the sample holder 5 and the first drive mechanism 66 can be retracted and so space in the vicinity of the point of intersection O within the sample chamber 8 can be effectively used. Furthermore, in the focused ion beam system 200, the sample holder 5 and the first drive mechanism 66 can be moved. This makes it unnecessary to match the length of the sample holder 5 to the size of the sample chamber 8. Consequently, in the focused ion beam system 200, FIB milling can be performed using a sample holder optimized for TEM.

The sample preparation method for use with the focused ion beam system 200 is similar to the sample preparation method for use with the above-described focused ion beam system shown in FIG. 9 except that a bulk sample is FIB milled in the bulk sample holder 204 mounted on the bulk sample stage 202 and a description thereof is omitted below.

In the focused ion beam system 200, the second drive mechanism 68 moves the sample holder 5 and the first drive mechanism 66 between the first position P1 where the sample holding portion 50 is located away from the optical axis of the ion beam optical system and the second position P2 where the sample holding portion 50 is on the optical axis of the ion beam optical system. In the focused ion beam system 200, therefore, the sample holder 5 and the first drive mechanism 66 can be moved as a unit into the second position P2 and, therefore, space in the vicinity of the point of intersection O within the sample chamber 8 can be effectively used.

### 3. Modifications

It is to be understood that the present invention is not restricted to the foregoing embodiments but rather can be practiced in variously modified forms without departing from the gist of the present invention. In the above-described first embodiment, the focused ion beam system 100 is equipped with both FIB column 2 and SEM column 3. Alternatively, the system 100 may be equipped with only the FIB column 2, in which case the intersection point O between the optical axes respectively of the FIB column 2 and the SEM column 3 is the position of the optical axis of the ion beam optical system of the FIB column 2.

The present invention is not restricted to the foregoing embodiments but rather implemented in variously modified forms. For example, the present invention embraces configurations (e.g., configurations identical in function and method) which are substantially identical to the configurations described in the above embodiments. Furthermore, the present invention embraces configurations which are similar to the configurations described in the above embodiments except that their nonessential portions have been replaced. Further, the present invention embraces configurations which are similar to the configurations described in any one of the above embodiments except that a well-known technique is added.

## Claims

1. A focused ion beam system comprising:
an electron optical column having an optical system for directing an ion beam at a sample;
a sample chamber in which the sample is placed and which can be maintained in a vacuum state;
a sample holder having a shaft and a sample holding portion which is formed in a front end of the shaft and which is operative to hold the sample; and
a sample stage assembly for detachably holding the sample holder;
wherein the sample stage assembly has a first drive mechanism for moving the sample holder and a second drive mechanism for moving the sample holder and the first drive mechanism as a unit along an axis of the shaft.

2. A focused ion beam system as set forth in claim 1, wherein said second drive mechanism moves said sample holder and said first drive mechanism between a first position at which said sample holding portion is located away from an optical axis of said optical system and a second position at which the sample holding portion is located on the optical axis of the optical system.

3. A focused ion beam system as set forth in claim 2,
wherein said second drive mechanism has both a stage base providing support of a cylindrical member into which said sample holder is inserted and a drive section for moving the stage base along the axis of said shaft;
wherein said sample stage has a base plate secured to a sample chamber wall that partitions said sample chamber; and
wherein when the sample holder and said first drive mechanism are located in said second position, a force acts on the sample holder such that the sample holder is drawn into the sample chamber in a vacuum state, whereby the stage base is pushed against the base plate.

4. A focused ion beam system as set forth in any one of claims 1 to 3, wherein said first drive mechanism includes a rotary driver for rotating said sample holding portion by rotating said shaft about its axis.

5. A focused ion beam system as set forth in claim 1, wherein said sample holder has a bulk sample stage for holding a bulk sample, and wherein said sample holding portion and the bulk sample stage are arranged in this order along the axis of said shaft in a direction going from a rear end to a front end of the shaft.

6. A focused ion beam system as set forth in claim 5, wherein said second drive mechanism moves said sample holder and said first drive mechanism between a first position at which said bulk sample stage is located on the optical axis of said optical system and a second position at which said sample holding portion is located on the optical axis of the optical system.

7. A focused ion beam system as set forth in claim 6;
wherein said first drive mechanism includes: a spherical bearing into which said sample holder is inserted and which rotatably supports the sample holder; and a drive section for rotating the sample holder about a fulcrum consisting of the spherical bearing; and
wherein the fulcrum and said bulk sample stage are spaced from each other by a distance greater than a distance by which the fulcrum and said sample holding portion are spaced from each other.

8. A focused ion beam system as set forth in claim 7, wherein neither the distance between said fulcrum and said sample holding portion nor the distance between the fulcrum and said bulk sample stage varies if said second drive mechanism moves said sample holder and said first drive mechanism as a unit.

9. A focused ion beam system as set forth in any one of claims 1 to 8, wherein said sample holder includes a refrigerant tank mounted in a rear end of said shaft and a heat transfer member thermally interconnecting the refrigerant tank and said sample holding portion.
